# EUROPEAN PATENT SPECIFICATION

(11) **EP 4 449 482 B1**
(45) Date of publication and mention of the grant of the patent: **24.09.2025**
(21) Application number: 22817285.4
(22) Date of filing: 16.11.2022
(51) Int. Cl.: H01L 21/322, H01L 21/762, H01L 21/28, H01L 21/20, H10D 30/47, H10D 62/85

(54) **GROUP III-NITRIDE SEMICONDUCTOR STRUCTURE ON SILICON-ON-INSULATOR AND METHOD OF GROWING THEREOF**
GRUPPE-III-NITRID-HALBLEITERSTRUKTUR AUF SILICIUM AUF ISOLATOR UND VERFAHREN ZU DEREN WACHSTUM
STRUCTURE SEMI-CONDUCTRICE AU NITRURE DU GROUPE III SUR SILICIUM SUR ISOLANT ET SON PROCÉDÉ DE CROISSANCE

(30) Priority: 16.12.2021 FR 2113655
(43) Date of publication of application: 23.10.2024
(73) Proprietor: SOITEC, 38190 Bernin (FR); Soitec Belgium, 3500 Hasselt (BE)
(72) Inventor: VEYTIZOU, Christelle, 38190 Bernin (FR); RADU, Ionut, 38190 Bernin (FR); DERLUYN, Joff, 3500 Hasselt (BE); DEGROOTE, Stefan, 3500 Hasselt (BE)
(74) Representative: IP HILLS NV
(86) International application number: PCT/EP2022/082085
(87) International publication number: WO 2023/110267

(56) References cited:
- US-A1- 2010 096 668
- US-A1- 2013 076 442
- US-A1- 2013 196 487
- US-A1- 2017 005 111
- US-A1- 2019 198 623

## Description

### Technical Field

The present invention generally relates, amongst others, to a semiconductor structure and to a method of growing thereof. More particularly, it relates to a semiconductor structure comprising Group III-nitride grown onto Silicon-On-Insulator, wherein the semiconductor structure achieves outstanding performance for high-power and high-frequency applications, and to a method of growing thereof.

### Background

Group III-nitride-based heterostructures are very suited for high-power and high-frequency applications due to their high electron velocity and high critical electric field. For example, AlGaN/GaN heterostructures are conventionally used for the manufacturing of field effect transistors also called FETs. In this heterostructure, a two dimensional electron gas, also referred to as 2DEG, is generated by the spontaneous and piezoelectric polarization between the two active layers, i.e. between AlGaN and GaN.

Group III-nitride-based heterostructures are typically manufactured on top of conventional silicon substrates. With the ever increasing need for high-power and high-frequency solutions, the telecommunication industry is faced with the challenge of making such Group III-nitride-based heterostructures compatible with existing technologies. For example, Group III-nitride-based heterostructures should allow the continued miniaturization of microelectronic devices and the continued improvement of their performance.

For high-power and high-frequency applications, it is essential to maximize the resistivity of the underlying substrate of the devices. However, measurements performed with spreading resistance profiling on gallium-nitride epitaxially grown onto a silicon substrate demonstrate a significant drop in resistivity versus depth in the heterostructure.

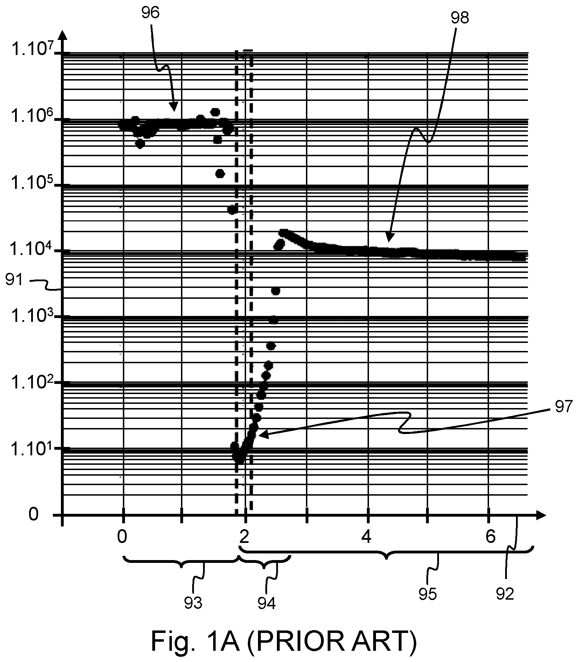

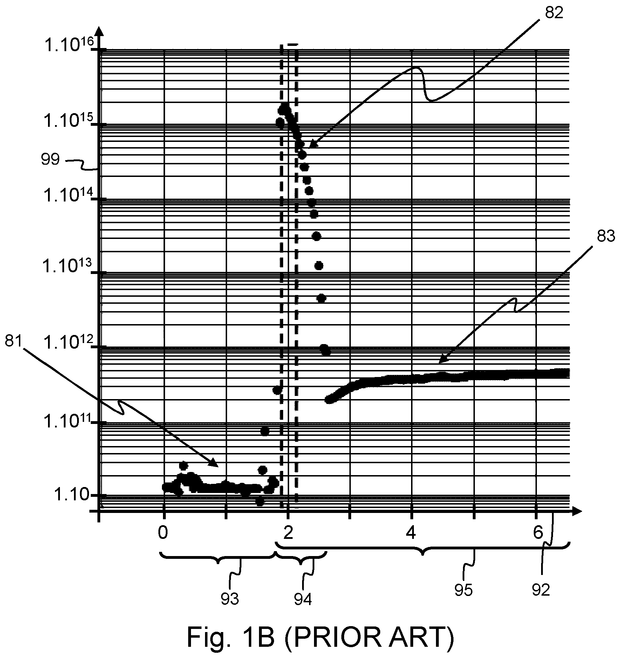

More generally, measurements performed with spreading resistance profiling on Group III-nitride heterostructures epitaxially grown on a silicon substrate demonstrate a similar drop in resistivity at the interface between the Group III-nitride heterostructure and the silicon substrate and similar presence of *p*-type dopants at the interface between the Group III-nitride heterostructure and the silicon substrate. Such presence of *p*-type dopants at the interface between Group III-nitride heterostructure and silicon is attributed to the diffusion or migration of impurities from the initial growth layer of the epitaxial layers of the Group III-nitride heterostructure to the silicon substrate. The impurities act as a *p*-type impurity for the silicon substrate. More particularly, such presence of *p*-type dopants at the interface between Group III-nitride heterostructure and silicon is attributed to the diffusion or migration of Group III elements into the silicon substrate in which they act as *p*-type impurities for the silicon substrate. For example, in the sample investigated in Fig. 1A and 1B of the present disclosure, such presence of *p*-type dopants at the interface between Group III-nitride heterostructure and silicon is attributed to the diffusion or migration of gallium and/or aluminium into the silicon substrate. Gallium and/or aluminium act as *p*-type impurities for silicon and thereby change the resistivity of the silicon substrate.

Several problems arise from such diffusion of Group III elements into the silicon substrate. For high-power and high-frequency applications, the presence of a high concentration of p-type dopants at the interface between gallium nitride and silicon will cause a capacitive coupling resulting in significant power dissipation and RF losses for components manufactured from this structure. Additionally, the diffusion of Group III elements into the silicon substrate will cause linearity problems to arise due to the generation of harmonic frequencies in components manufactured from this structure.
US 2019/198623 A1 discloses a group III-nitride HEMT formed on a SOI substrate.

### Summary

It is thus an object of embodiments of the present invention to propose a semiconductor structure and a manufacturing method which do not show the inherent shortcomings of the prior art. More specifically, it is an object of embodiments of the present invention to propose a semiconductor structure with improved performance at high-power and high-frequency and a manufacturing method thereof.

The scope of protection sought for various embodiments of the invention is set out by the independent claims.

The embodiments and features described in this specification that do not fall within the scope of the independent claims, if any, are to be interpreted as examples useful for understanding various embodiments of the invention.

There is a need for a semiconductor structure which demonstrates improved resistivity, and reduced power losses and linearity problems. Additionally, there is a need for a semiconductor structure which, from a manufacturing perspective, is compatible with existing technologies.

This object is achieved, according to a first example aspect of the present disclosure, by a semiconductor structure comprising:
- a Silicon-On-Insulator substrate comprising:
   ∘ a base layer comprising silicon;
   ∘ an intermediate layer formed on top of the base layer; and
   ∘ a top layer formed on top of the intermediate layer;
- an epitaxial III-N semiconductor layer stack on top of the Silicon-On-Insulator substrate, the epitaxial III-N semiconductor layer stack comprising an epitaxial active layer; wherein the epitaxial active layer comprises:
   ∘ a first active III-N layer formed on top of the top layer;
   ∘ a second active III-N layer formed on top of the diffusion barrier layer;
   with a two dimensional Electron Gas between the first active III-N layer and the
   second active III-N layer;
and wherein:
- the top layer comprises n-type doped silicon; and
- the intermediate layer comprises:
   ∘ a trap-rich layer; and
   ∘ a buried insulator formed on top of a trap-rich layer.

As previously mentioned, presence of *p*-type dopants at the interface between the Group III-nitride heterostructure and a silicon substrate onto which the Group III-nitride heterostructure is for example epitaxially grown can be measured with for example spreading resistance profiling measurements. Such presence of *p*-type dopants at the interface between Group III-nitride heterostructure and silicon is attributed to the diffusion or migration of impurities from the initial growth layer of the epitaxial layers of the Group III-nitride heterostructure to the silicon substrate. The impurities act as a *p*-type impurity for the silicon substrate. More particularly, such presence of *p*-type dopants at the interface between Group III-nitride heterostructure and silicon is attributed to the diffusion or migration of Group III elements into the silicon substrate in which they act as *p*-type impurities for the silicon substrate.

With the semiconductor structure according to the present disclosure, the diffusion or migration of Group III elements from the epitaxial layers of the Group III-nitride heterostructure into the Silicon-On-Insulator substrate is contained in a surface region of the Silicon-On-Insulator substrate close to the epitaxial layers of the Group III-nitride heterostructure, for example in the top layer and optionally close to the interface between the intermediate layer and the top layer. Indeed, the intermediate layer of the Silicon-On-Insulator substrate according to the present disclosure confines the diffusion or migration of Group III elements within the surface region of the Silicon-On-Insulator substrate close to the epitaxial layers of the Group III-nitride heterostructure, for example in the top layer and optionally close to the interface between the intermediate layer and the top layer, thereby shortening the diffusion distance of the impurities into the Silicon-On-Insulator substrate.

With the semiconductor structure according to the present disclosure, the n-type doping of the top layer of the Silicon-On-Insulator substrate according to the present disclosure compensates for the concentration of Group III elements which diffuses from the epitaxial layers into the Silicon-On-Insulator substrate. In other words, the *n-*type doping of the top layer of the Silicon-On-Insulator substrate according to the present disclosure balances out a concentration of *p*-type dopants at the interface between the epitaxial layers and the Silicon-On-Insulator substrate, wherein the concentration of these *p*-type dopants results from a diffusion of Group III atoms from said epitaxial III-N semiconductor layer stack into the top layer of the Silicon-On-Insulator substrate.

This way, the semiconductor structure according to the present disclosure demonstrates improved performance at high-power and high-frequency, improved resistivity, and reduced power losses and linearity problems.

The use of a trap-rich layer has been proven as one of the most effective techniques to reduce these parasitic effects and to enhance the high-resistivity properties of silicon, while being compatible with industrial SOI wafer fabrication and with the important thermal budget of standard CMOS process. The traps of the trap-rich layer capture the free carriers at the interface between the silicon and the intermediate layer, thereby enabling the Silicon-On-Insulator substrate to recover its nominal resistivity, linearity, eliminating the DC dependency and leading to a substantial reduction of RF losses and crosstalk. In the context of the present disclosure, the trap-rich layer has a defect density suitable for trapping free charges that may be generated in the Silicon-On-Insulator substrate. The trap-rich layer may provide a trapping effect as well. The trap-rich layer has a thickness of several tens of nanometers to several microns, for example, 50 nm to 3 microns. The trap-rich layer comprises silicon, or amorphous silicon carbide, or polycrystalline silicon also referred to as polysilicon.

In the context of the present disclosure, a two-dimensional electron gas, also referred to as 2DEG, is a gas of electrons free to move in two dimensions, but tightly confined in the first. This tight confinement leads to quantized energy levels for motion in that direction. The electrons appear to be a 2D sheet embedded in a 3D world.

In the context of the present disclosure, Group III-nitride refers to semiconductor compounds formed between elements in Group III of the periodic table, for example Boron, also referred to as B, Aluminum, also referred to as Al, Gallium, also referred to as Ga, Indium, also referred to as In, and Nitrogen, also referred to as N. Example of binary Group III-nitride compounds are GaN, AIN, BN, etc.. Group III-nitride also refers to ternary and quaternary compounds such as for example AlGaN and InAlGaN.

In the context of the present disclosure, the first active III-N layer comprises one or more of N, P, As, and one or more of B, Al, Ga, In and Tl. The first active III-N layer for example comprises GaN. The second active III-N layer comprises one or more of N, P, As, and one or more of B, Al, Ga, In, and Tl. The second active III-N layer for example comprises AlGaN. The term AlGaN relates to a composition comprising Al, Ga and N in any stoichiometric ratio (AlₓGa_{y}N) wherein x is comprised between 0 and 1 and y is comprised between 0 and 1. Alternatively, the second active III-N layer for example comprises AIN. Alternatively, the second active III-N layer comprises InAlGaN. A composition such as InAlGaN comprises In in any suitable amount. Alternatively, both first active III-N layer and second active III-N layer comprise InAlGaN, and the second active III-N layer comprises a bandgap larger than a bandgap of the first active III-N layer and wherein the second active III-N layer comprises a polarization larger than the polarization of the first active III-N layer. Alternatively, both first active III-N layer and second active III-N layer comprise BInAlGaN, and the second active III-N layer comprises a bandgap larger than a bandgap of the first active III-N layer and wherein the second active III-N layer comprises a polarization larger than the polarization of the first active III-N layer. Compositions of the active layer may be chosen in view of characteristics to be obtained, and compositions may vary accordingly. For example, good results were obtained with a first active III-N layer comprising GaN of about 150 nm thickness and a second active III-N layer comprising AlGaN of about 20 nm thickness.

In the context of the present disclosure, the base layer of the Silicon-On-Insulator substrate comprises bulk silicon and a resistivity of the base layer of the Silicon-On-Insulator substrate is typically comprised between 3 and 5 kOhm.cm, and is preferably higher than 1 kOhm.cm. This way, the resistivity of the substrate underlying the epitaxial III-N semiconductor layer stack is maximized for high-power and high-frequency applications.

In the context of the present disclosure, the technology of Silicon-On-Insulator, also referred to as SOI, corresponds to the manufacturing of semiconductor devices in a layered silicon-insulator-silicon substrate. The choice of insulator depends largely on the intended application of the semiconductor devices. Several types of Silicon-On-Insulator substrates may be used within the context of the present disclosure.

Due to the isolation from the bulk silicon of the base layer of the Silicon-On-Insulator substrate, parasitic capacitance within the semiconductor devices manufactured from the Group III-nitride heterostructure is lowered, thereby improving their power consumption and their performance. The semiconductor devices manufactured on Silicon-On-Insulator also demonstrate a higher resistance to latchup and a higher performance at equivalent VDD than semiconductor devices integrated on other types of substrates. The temperature dependency of the semiconductor devices manufactured on SOI is reduced compared to semiconductor devices integrated on other types of substrates. Due to the isolation, the semiconductor devices manufactured on SOI demonstrate lower leakage currents and consequently higher power efficiency.

Radio-Frequency Silicon-On-Insulator substrates, also referred to as RF-SOI substrates, enable high RF performance on silicon films compatible with standard CMOS processes, high linearity RF isolation and power signals, low RF loss, digital processing and power management integration.

For example, an enhanced signal integrity substrate for RF application comprises a base layer comprising high-resistive silicon, a trap rich layer formed on top of the base layer, a buried insulator formed on top of the trap rich layer, and a top layer formed on top of the buried insulator, wherein the top layer comprises a monocrystal. A resistivity of the base layer is typically over 3 kOhm.cm. A thickness of the top layer is typically comprised between 50nm and 200nm. The addition of a trap-rich layer provides outstanding RF performances. Such substrate is particularly suited for devices with stringent linearity specifications. Applications typically target for example LTE-Advanced and 5G specifications and address different performance requirements. Compared to a high-resistive SOI substrate, an enhanced signal integrity substrate demonstrates better linearity, lower RF losses, lower crosstalk, improved quality factors for passives, smaller die sizes and higher thermal conductivity. Enhanced signal integrity substrates further typically demonstrate an harmonic quality factor lower than -80dBm.

Another example of a RF-SOI comprises a base layer comprising mid-resistive silicon, a trap-rich layer formed on top of the base layer, a buried insulator formed on top of the trap-rich layer, and a top layer comprising a thin monocrystal. Such substrate is particularly suited for for example cost sensitive highly integrated devices, and is particularly well suited to for example Wi-Fi, loT and other consumer applications specifications.

Another example of a RF-SOI called high-resistive SOI targets for example devices with lower linearity specifications and 2G and 3G specifications. Such substrate comprises a base layer comprising high-resistive silicon, a buried insulator formed on top of the base layer and a top layer comprising a thin monocrystal.

Power Silicon-On-Insulator substrates address the requirements for integrating for example high-voltage and analog functions in intelligent, energy-efficient and highly reliable power IC devices, for automotive and industry markets. They provide excellent electrical isolation and are perfect for integrating devices operating at different voltages from a few volts to several hundred volts while reducing die area and improving reliability. These substrates are ideal for applications such as CAN/LIN transceivers, switch mode power supplies, brushless motor drivers, LED drivers, and more. A power SOI comprises a base layer comprising silicon, a buried insulator formed on top comprising oxide, and a top layer comprising silicon. A thickness of the buried insulator is typically comprised between 0.4µm to 1µm and a thickness of the top layer is comprised typically between 0.1µm and 1.5µm.

Photonics Silicon-On-Insulator substrates address the requirement of optical function integration onto for example a CMOS chip for low-cost and high-speed optical transceivers. Such a substrates comprises a base layer comprising silicon, a buried insulator formed on top of the base layer and comprising oxide, and a top layer formed on top of the buried insulator and comprising monocrystalline silicon. A thickness of the buried insulator is typically comprised between 0.7µm to 2µm and a thickness of the top layer is comprised typically between 0.1µm and 0.5µm. The crystalline silicon layer on insulator can be used to fabricate for example optical waveguides and other optical devices, either passive or active, e.g. through suitable implantations. The buried insulator enables for example the propagation of infrared light in the silicon layer on the basis of total internal reflection. The top surface of the waveguides can be either left uncovered and exposed to air, e.g. for sensing applications, or covered with a cladding, for example made of silica.

From a manufacturing perspective, SOI substrates are compatible with most conventional fabrication processes. In general, an SOI-based process may be implemented without special equipment or significant retooling of an existing factory. Among challenges unique to SOI are novel metrology requirements to account for the buried insulator and concerns about differential stress in the top layer comprising silicon.

According to example embodiments, a n-type doping concentration of the top layer is within the range of 1.10¹⁵ cm⁻³ to 5.10¹⁵ cm⁻³.

This way, the n-type doping of the top layer of the Silicon-On-Insulator substrate compensates and balances out for the concentration of Group III elements which diffuses from the epitaxial layers into the top layer of the Silicon-On-Insulator substrate.

According to example embodiments, a thickness of the top layer is comprised between 50 and 200nm. Alternatively, a thickness of the top layer is lower than 100nm.

This way, the intermediate layer confines the diffusion or migration of Group III elements within the thin silicon layer formed by the top layer. In other words, the intermediate layer confines the diffusion or migration of Group III elements to the surface region of the Silicon-On-Insulator substrate close to the epitaxial layers of the Group III-nitride heterostructure. The semiconductor structure then demonstrates improved performance at high-power and high-frequency, improved resistivity, and reduced power losses and linearity problems.

According to example embodiments, the top layer comprises *n*-type doped silicon, wherein an orientation of the *n*-type doped silicon of the top layer is (111).

According to example embodiments, the top layer comprises monocrystalline silicon.

This way, the monocrystalline silicon of the top layer can be used to fabricate for example optical waveguides and other optical devices, either passive or active, e.g. through suitable implantations. The buried insulator enables for example the propagation of infrared light in the silicon of the top layer on the basis of total internal reflection. The top surface of the waveguides manufactured within the top layer can be either left uncovered and exposed to air, e.g. for sensing applications, or covered with a cladding, for example made of silica.

According to example embodiments, the buried insulator comprises amorphous silicon carbide and the trap-rich layer comprises amorphous silicon carbide.

This way, amorphous silicon carbide acts as a trap-rich and as a barrier containing the diffusion or migration of Group III elements from the epitaxial layers of the Group III-nitride heterostructure into the Silicon-On-Insulator substrate in a surface region of the Silicon-On-Insulator substrate close to the epitaxial layers of the Group III-nitride heterostructure, for example in the top layer and optionally close to the interface between the intermediate layer and the top layer. Alternatively, the trap-rich layer comprises silicon or polysilicon.

According to example embodiments, the buried insulator comprises silicon dioxide and the trap-rich layer comprises silicon.

According to example embodiments, the buried insulator comprises silicon dioxide and the trap-rich layer comprises amorphous silicon carbide.

Alternatively, the trap-rich layer comprises polysilicon.

According to example embodiments, the buried insulator comprises a layer comprising silicon nitride confined between two layers comprising silicon oxide; and the trap-rich layer comprises amorphous silicon carbide.

In this example embodiment, the buried insulator comprises an ONO dielectric stack, wherein ONO stands for oxide-nitride-oxide. The buried insulator results in better thermal conduction than silicon dioxide without excessively deteriorating parasitic capacitive coupling nor jeopardizing high-speed performance of for example active devices manufactured from the semiconductor structure according to the present disclosure. Additionally, the buried insulator comprising a layer comprising silicon nitride further enhances the technical effect of containing the diffusion or migration of Group III elements from the epitaxial layers of the Group III-nitride heterostructure into the Silicon-On-Insulator substrate in a surface region of the Silicon-On-Insulator substrate close to the epitaxial layers of the Group III-nitride heterostructure, for example in the top layer and optionally close to the interface between the intermediate layer and the top layer. Blocking the diffusion of Group III elements from the epitaxial layers of the Group III-nitride heterostructure into the Silicon-On-Insulator substrate is more efficient in a semiconductor structure comprising a buried insulator comprising silicon nitride than in a semiconductor structure comprising a buried insulator comprising only silicon dioxide. Alternatively, the trap-rich layer comprises silicon or polysilicon.

According to example embodiments, the silicon carbide is amorphous.

The traps of the amorphous silicon carbide of the trap-rich layer capture the free carriers at the interface between the silicon of the top layer and the intermediate layer, thereby enabling the Silicon-On-Insulator substrate to recover its nominal resistivity, linearity, eliminating the DC dependency and leading to a substantial reduction of RF losses and crosstalk.

According to example embodiments, a thickness of the trap-rich layer is comprised between tens of nanometers and several micrometers. For example, a thickness of the trap-rich layer comprising amorphous silicon carbide can reach a few tens of nanometers. Alternatively, a thickness of the trap-rich layer comprising polysilicon can reach a few micrometers.

According to example embodiments, a thickness of the buried insulator is comprised between 100nm and 500nm.

According to example embodiments, a thickness of the intermediate layer comprising the buried insulator and the trap-rich layer is comprised between a few hundreds of nanometers and a few micrometers.

According to example embodiments, the epitaxial III-N semiconductor layer stack further comprises a spacer layer formed between the first active III-N layer and the second active III-N layer.

This way, the spacer layer epitaxially grown between the first active III-N layer and the second active III-N layer enhances the electron mobility within the epitaxial III-N semiconductor layer stack.

According to example embodiments, the first active III-N layer comprises gallium nitride and wherein the second active III-N layer comprises aluminium gallium nitride.

Preferably, the first active III-N layer is grown epitaxially and comprises pure gallium nitride, preferably a monolayer of gallium nitride.

According to example embodiments, the first active III-N layer comprises InAlGaN, and the second active III-V layer comprises InAlGaN, and the second active III-N layer comprises a bandgap larger than a bandgap of the first active III- N layer and the second active III-N layer comprises a polarization larger than the polarization of the first active III-N layer.

This way, the use of different materials in adjacent first active III-N layer and second III-V layer causes polarization which contributes to a conductive 2DEG region near the junction between the first active III-N layer and the second active III-N layer, in particular in the first active III-N layer which comprises a bandgap narrower than the bandgap of the second active III-N layer.

The first active III-N layer for example has a thickness comprised between 20 and 500 nm, preferably between 30 and 300 nm, more preferably between 50 and 250 nm, such as for example from 100 to 150 nm. The second active III-N layer for example has a thickness comprised between 10 to 100 nm, preferably between 20 to 50 nm. Such a combination of thicknesses provides good characteristics for the active layer, for example in terms of the 2DEG obtained.

According to example embodiments, the spacer layer comprises aluminium nitride.

Preferably, the spacer layer is grown epitaxially and comprises pure aluminum nitride.

According to example embodiments, a thickness of the spacer layer is lower than 2nm.

This way, the spacer layer is kept thin enough to minimize the roughness of the spacer layer. With minimized roughness, the spacer layer prevents the diffusion or the migration of Group III atoms into at least the first active III-N layer. This way, the thermal stability of the semiconductor structure is further improved. In other words, the thinner the spacer layer, the better the thermal stability of the semiconductor structure. Preferably, the thickness of the spacer layer is comprised between 0.5nm and 1.5nm. Even more preferably, the thickness of the spacer layer is comprised between 0.8nm and 1nm.

According to example embodiments, the epitaxial III-N semiconductor layer stack further comprises an epitaxially grown buffer layer grown between the substrate and the epitaxial active layer.

The buffer layer may be of a different nature than the substrate, in that for instance the bandgap of the substrate and buffer layer are relatively far apart such as 1.1 eV and 6.2 eV respectively, in the sense that the buffer layer has a high bandgap, in order to provide present characteristics, such as high break down voltage, e.g. larger than 250 V, preferably larger than 500 V, even more preferably larger than 1000 V, such as larger than 2000 V, or even much larger. The buffer layer is for example a III-V buffer layer with a high bandgap. Therein III refers to Group III elements, such as B, Al, Ga, In, Tl, Sc, Y and Lanthanide and Actinide series. Therein V refers to Group V elements, such as N, P, As, Sb, Bi. The buffer layer may comprise a stack of layers, in an example typically the first one being a nucleation layer.

According to example embodiments, the semiconductor structure further comprises a passivation stack formed on top of the epitaxial III-N semiconductor layer.

The passivation stack is formed in-situ with the formation of the epitaxial III-N semiconductor layer stack. The passivation stack is for example formed on top of the second active III-N layer. This way, a fully crystalline passivation stack is epitaxially grown on top of the epitaxial III-N semiconductor layer stack. Alternatively, a partially crystalline passivation stack is epitaxially grown on top of the epitaxial III-N semiconductor layer stack. The passivation stack may also be formed by ex-situ deposition with the help of epitaxy tools like atomic layer deposition, also referred to as ALD, chemical vapor deposition, also referred to as CVD, or physical vapor deposition, also referred to as PVD. Alternatively, the passivation stack may be formed by in-situ deposition in a MOCVD or an MBE chamber. Alternatively, the passivation stack may be formed by depositing an amorphous film of the same material and recrystallizing it using thermal anneal. The passivation stack on top of the second active III-N layer for example comprises Gallium Nitride. Alternatively, the passivation stack on top of the second active III-N layer comprises Gallium Nitride and Silicon Nitride.

A passivation stack is formed between the epitaxial III-N semiconductor layer stack and for example a gate of a transistor. The passivation stack may be formed only under the gate and may serve additionally as gate dielectric. Alternatively, the passivation stack may be formed on top of the epitaxial III-N semiconductor layer stack and may fully cover the epitaxial III-N semiconductor layer stack. Alternatively, the passivation stack may be formed on top of the epitaxial III-N semiconductor layer stack and partially cover the surface of the epitaxial III-N semiconductor layer stack, for example it may be formed in the ungated area between the source and the drain of a high mobility electron transistor, where it serves as passivation and prevents the depletion of the underlying 2DEG.

According to example embodiments, the passivation stack further comprises an oxide layer and/or silicon nitride.

This way, the passivation layer of the semiconductor structure according to a first example aspect of the present disclosure comprises silicon nitride and/or an oxide layer which acts as a passivation layer. The oxide layer exhibits an electrically clean interface to the second active III-N layer, a high dielectric constant to maximize electrostatic coupling between electrical contacts formed onto the semiconductor structure and the 2DEG which results in an increase of for example the transconductance of high electron mobility transistors manufactured with the semiconductor structure and a sufficient thickness to avoid dielectric breakdown and leakage by quantum tunneling.

According to a second example aspect of the present disclosure, there is provided a method for manufacturing a semiconductor structure, wherein the method comprises the steps of:
- providing a Silicon-On-Insulator substrate comprising:
   ∘ providing a base layer comprising silicon;
   ∘ providing an intermediate layer on top of the base layer by:
      ▪ providing a trap-rich layer; and
      ▪ providing a buried insulator formed on top of the trap-rich layer; and
   ∘ providing a top layer comprising n-type doped silicon and formed on top of the intermediate layer;
- providing an epitaxial III-N semiconductor layer stack on top of the Silicon-On-Insulator substrate, the epitaxial III-N semiconductor layer stack comprising an epitaxial active layer; wherein providing the epitaxial active layer comprises the steps of:
   ∘ providing a first active III-N layer on top of the top layer;
   ∘ providing a second active III-N layer on top of the first active III-N layer; thereby forming a two dimensional Electron Gas between the first active III-N layer and the second active III-N layer.

As previously mentioned, presence of p-type dopants at the interface between the Group III-nitride heterostructure and a silicon substrate onto which the Group III-nitride heterostructure is for example epitaxially grown can be measured with for example spreading resistance profiling measurements. Such presence of p-type dopants at the interface between Group III-nitride heterostructure and silicon is attributed to the diffusion or migration of impurities from the initial growth layer of the epitaxial layers of the Group III-nitride heterostructure to the silicon substrate. The impurities act as a p-type impurity for the silicon substrate. More particularly, such presence of p-type dopants at the interface between Group III-nitride heterostructure and silicon is attributed to the diffusion or migration of Group III elements into the silicon substrate in which they act as p-type impurities for the silicon substrate.

With the method for manufacturing a semiconductor structure according to the present disclosure, the diffusion or migration of Group III elements from the epitaxial layers of the Group III-nitride heterostructure into the Silicon-On-Insulator substrate is contained in a surface region of the Silicon-On-Insulator substrate close to the epitaxial layers of the Group III-nitride heterostructure, for example in the top layer and optionally close to the interface between the intermediate layer and the top layer. Indeed, with the method according to the present disclosure, the intermediate layer of the Silicon-On-Insulator substrate confines the diffusion or migration of Group III elements within the surface region of the Silicon-On-Insulator substrate close to the epitaxial layers of the Group III-nitride heterostructure, for example in the top layer and optionally close to the interface between the intermediate layer and the top layer, thereby shortening the diffusion distance of the impurities into the Silicon-On-Insulator substrate.

With the method for manufacturing a semiconductor structure according to the present disclosure, the *n*-type doping of the top layer of the Silicon-On-Insulator substrate compensates for the concentration of Group III elements which diffuses from the epitaxial layers into the Silicon-On-Insulator substrate. In other words, the *n*-type doping of the top layer of the Silicon-On-Insulator substrate balances out a concentration of *p*-type dopants at the interface between the epitaxial layers and the Silicon-On-Insulator substrate, wherein the concentration of these *p*-type dopants results from a diffusion of Group III atoms from said epitaxial III-N semiconductor layer stack into the top layer of the Silicon-On-Insulator substrate.

This way, the semiconductor structure manufactured with the method according to the present disclosure demonstrates improved performance at high-power and high-frequency, improved resistivity, and reduced power losses and linearity problems.

The epitaxial III-N semiconductor layer stack comprises an epitaxial active layer which comprises the first active III-N layer, optionally a spacer layer, and the second active III-N layer. The epitaxial active layer is formed in-situ by epitaxial growth in a metal-organic chemical vapour deposition epitaxial chamber, also referred to as MOCVD, or in a metal-organic vapour phase epitaxial chamber, also referred to as MOVPE, or in a molecular beam epitaxial chamber, also referred to as MBE, or in a chemical beam epitaxial chamber, also referred to as CBE.

The semiconductor structure can be formed by epitaxial growth by metal-organic chemical vapour deposition (MOCVD) or metal-organic vapour phase epitaxy (MOVPE) or be molecular beam epitaxy (MBE) or chemical beam epitaxy (CBE). In the MOVPE or in the MOCVD process, the epitaxial III-N semiconductor layer stack is epitaxially grown on a Silicon-On-Insulator substrate, typically at pressures for example comprised between 5 mBar and 1 Bar and typically at temperatures for example comprised between 600°C and 1200°C. The precursor materials can be but are not limited to ammonia (NH₃) for nitrogen; tri-methyl-Ga (TMGa) or tri-ethyl-Ga (TEGa) for gallium, tri-methyl-Al (TMAI) or tri-ethyl-Al (TEAl) for aluminium; tri-methyl-Indium (TMln) for indium; and silane (SiH₄) or disilane (SiH₃)₂ for silicon.

The Silicon-On-Insulator substrate may comprise a buried insulator which comprises silicon oxide. The Silicon-On-Insulator substrate may then be produced by several methods such as for example a Separation by IMplantation of Oxygen, known as SIMOX, or wafer bonding, or by a seed method.

According to example embodiments, the providing a top layer comprising n-type doped silicon comprises doping the silicon of the top layer by thermal diffusion of *n-*type dopants into the silicon of the top layer.

Preferably, a n-type doping concentration of the top layer is within the range of 1.10¹⁵ cm⁻³ to 5.10¹⁵ cm⁻³.

According to example embodiments, the providing a top layer comprising *n*-type doped silicon comprises doping the silicon of the top layer by ion implantation of *n*-type dopants into the silicon of the top layer.

Preferably, a *n*-type doping concentration of the top layer is within the range of 1.10¹⁵ cm⁻³ to 5.10¹⁵ cm⁻³.

According to example embodiments, the *n*-type dopants comprise one or more of the following:
- Phosphorus;
- Arsenic;
- Antimony.

### Brief Description of the Drawings

Some example embodiments will now be described with reference to the accompanying drawings.
Figs. 1A and 1B schematically depict an example embodiment according to the prior art of measurements performed with spreading resistance profiling on gallium-nitride epitaxially grown onto a silicon substrate.
Fig. 2 schematically depicts an example embodiment of a semiconductor structure according to the present disclosure.
Fig. 3 schematically depicts an example embodiment of a semiconductor structure according to the present disclosure, wherein the buried insulator comprises a layer comprising silicon nitride confined between two layers comprising silicon dioxide.
Fig. 4 schematically depicts an example embodiment of a semiconductor structure according to the present disclosure, wherein the epitaxial III-N semiconductor layer stack further comprises a spacer between the first active III-N layer and the second active III-N layer.

### Detailed Description of Embodiment(s)

Fig. 1A schematically illustrates an example embodiment according to the prior art of measurements performed with spreading resistance profiling on gallium-nitride epitaxially grown onto a silicon substrate. Indeed, Fig. 1A schematically illustrates the resistivity 91 in logarithmic scale of a sample comprising gallium-nitride epitaxially grown on silicon as a function of depth 92 within the gallium-nitride on silicon heterostructure. On Fig. 1A, the section 93 corresponds to gallium nitride and the section 95 corresponds to a portion of the silicon substrate. The section 94 on Fig. 1A corresponds to the interface between the gallium nitride and the silicon substrate. As visible on Fig. 1A, the resistivity 96 measured within the gallium nitride is almost constant throughout the layer and equal to 1.10⁶ Ohm.cm, while the resistivity 98 measured from almost 1µm within the silicon substrate is almost constant and equal to 1.10⁴ Ohm.cm. However, at the interface 94 between the gallium nitride and the silicon substrate, and as visible on Fig. 1A, a significant drop in resistivity 97 is measured by spreading resistance profiling. More precisely, the resistivity 97 in section 94 of the heterostructure drops from 1.10⁶ Ohm.cm to 1.10¹ Ohm.cm before slowly increasing back to 1.10⁴ Ohm.cm deeper into the silicon substrate. As visible on Fig. 1A, the drop in resistivity 97 extends over 0.5µm to almost 1µm into the silicon substrate.

The drop in resistivity at the interface between the gallium nitride and the silicon substrate is further investigated with spreading resistance profiling measurements. The results of such measurements are for example depicted on Fig. 1B. Fig. 1B schematically illustrates a concentration of species in logarithmic scale and their type within the same sample comprising gallium-nitride epitaxially grown on a silicon substrate as characterized on Fig. 1A. On Fig. 1B, the section 93 corresponds to gallium nitride and the section 95 corresponds to a portion of the silicon substrate. The section 94 on Fig. 1B corresponds to the interface between the gallium nitride and the silicon substrate. As visible on Fig. 1B, gallium-nitride in this sample is almost undoped and demonstrating a concentration 81 lower than 2.10¹⁰ atoms.cm⁻³, while the silicon substrate is this sample demonstrates from almost 1µm within the silicon substrate a concentration 83 varying from 2.10¹¹ atoms.cm⁻³ to 6.10¹¹ atoms.cm⁻³. However, at the interface 94 between the gallium nitride and the silicon substrate, and as visible on Fig. 1B, a significant concentration of *p*-type dopants 82 is measured by spreading resistance profiling. More precisely, this concentration 82 increases from 2.10¹⁰ atoms.cm⁻³ close to the gallium nitride to reach 2.10¹⁵ atoms.cm⁻³ in section 94 and the concentration 82 then slowly decreases again into the silicon substrate to a concentration of 2.10¹¹ atoms.cm⁻³. Conclusion can be drawn from such spreading resistance profiling measurements that a high concentration of *p*-type dopants is present at the interface between gallium nitride and silicon and extending over 0.5µm to almost 1µm into the silicon substrate.

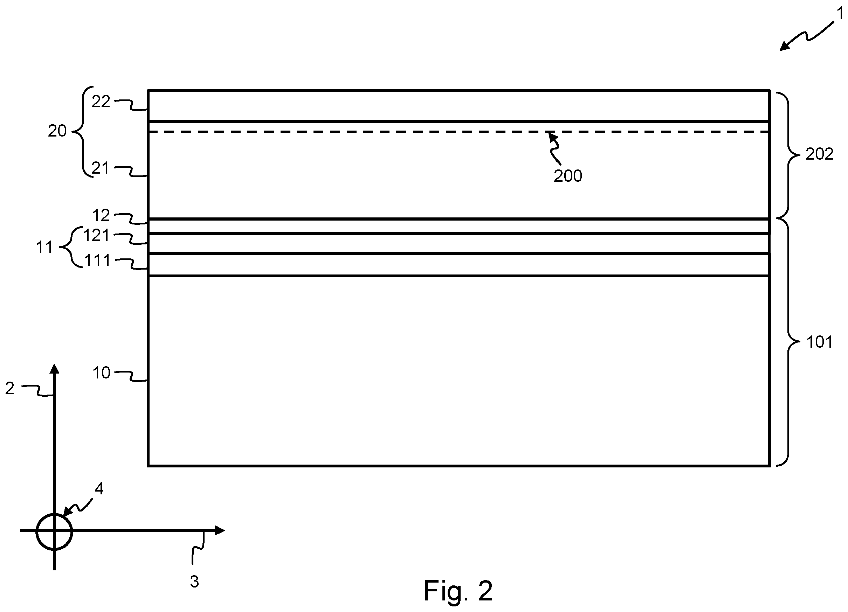

Fig. 2 schematically depicts a cross-section of an example embodiment of a semiconductor structure 1 according to the present disclosure, wherein the cross-section is performed along a plane comprising a growth direction 2, and a traverse direction 3 traverse to the growth direction 2. A third direction 4 is traverse to the growth direction 2 and to the traverse direction 3. The semiconductor structure 1 comprises a Silicon-On-Insulator substrate 101 and an epitaxial III-N semiconductor layer stack 202 on top of the Silicon-On-Insulator substrate 101. The Silicon-On-Insulator substrate 101 comprises a base layer 10, an intermediate layer 11 formed on top of the base layer 10, and a top layer 12 formed on top of the intermediate layer 11. The base layer 10 comprises silicon. The resistivity of the base layer 10 is typically comprised between 3 and 5 kOhm.cm, larger than 1 kOhm.cm. The epitaxial III-N semiconductor layer stack 202 comprises an epitaxial active layer 20. The epitaxial active layer 20 comprises a first active III-N layer 21 formed on top of the top layer 12 and a second active III-N layer formed on top of the first active III-N layer 21. The first active III-N layer 21 comprises for example gallium nitride and the second active III-N layer 22 for example comprises aluminium gallium nitride. A two dimensional Electron Gas 200 is formed between the first active III-N layer 21 and the second active III-N layer 22. The top layer 12 comprises n-type doped silicon. An orientation of the silicon of the top layer 12 is (111). The n-type doping concentration of the top layer 12 is within the range of 1.10¹⁵ cm⁻³ to 5.10¹⁵ cm⁻³. A thickness of the top layer 12 is comprised between 50 and 200nm. According to an alternative embodiment, a thickness of the top layer 12 is lower than 100nm. The intermediate layer 11 comprises a trap-rich layer 111 and a buried insulator 121 formed on top of the trap-rich layer 111. The buried insulator 121 comprises silicon dioxide and the trap-rich layer 111 comprises silicon. A thickness of the buried insulator 121 is comprised between 100nm and 500nm. A thickness of the trap-rich layer 111 can be for example several micrometers. According to an alternative embodiment, the buried insulator 121 comprises silicon dioxide and the trap-rich layer 111 comprises silicon carbide, for example amorphous silicon carbide. A thickness of the trap-rich layer 111 can be for example tens of nanometers.

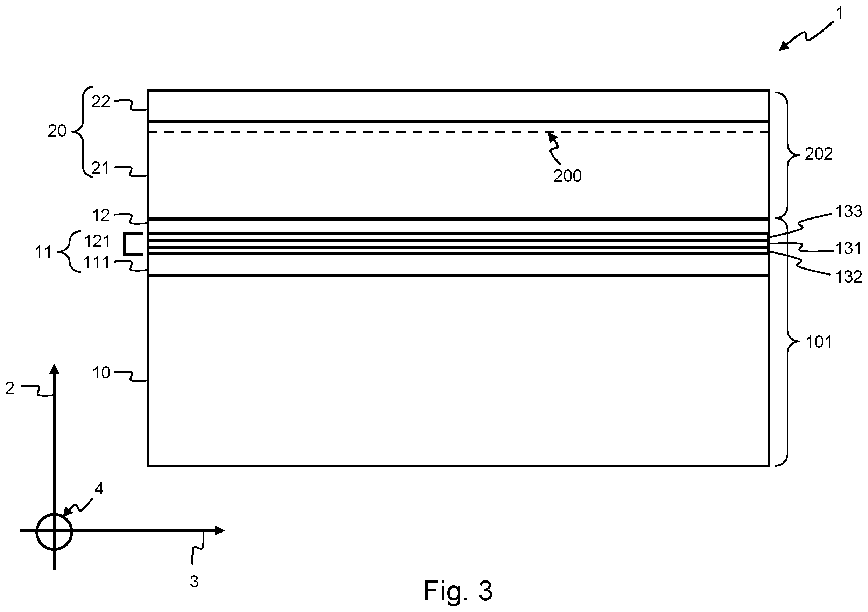

Fig. 3 schematically depicts a cross-section of an example embodiment of a semiconductor structure 1 according to the present disclosure, wherein the cross-section is performed along a plane comprising a growth direction 2, and a traverse direction 3 traverse to the growth direction 2. A third direction 4 is traverse to the growth direction 2 and to the traverse direction 3. Components having identical reference numbers than on Fig. 2 fulfill the same function. The semiconductor structure 1 comprises a Silicon-On-Insulator substrate 101 and an epitaxial III-N semiconductor layer stack 202 on top of the Silicon-On-Insulator substrate 101. The Silicon-On-Insulator substrate 101 comprises a base layer 10, an intermediate layer 11 formed on top of the base layer 10, and a top layer 12 formed on top of the intermediate layer 11. The base layer 10 comprises silicon. The resistivity of the base layer 10 is typically comprised between 3 and 5 kOhm.cm, larger than 1 kOhm.cm. The epitaxial III-N semiconductor layer stack 202 comprises an epitaxial active layer 20. The epitaxial active layer 20 comprises a first active III-N layer 21 formed on top of the top layer 12 and a second active III-N layer formed on top of the first active III-N layer 21. The first active III-N layer 21 comprises for example gallium nitride and the second active III-N layer 22 for example comprises aluminium gallium nitride. A two dimensional Electron Gas 200 is formed between the first active III-N layer 21 and the second active III-N layer 22. The top layer 12 comprises *n*-type doped silicon. An orientation of the silicon of the top layer 12 is (111). The *n*-type doping concentration of the top layer 12 is within the range of 1.10¹⁵ cm⁻³ to 5.10¹⁵ cm⁻³. A thickness of the top layer 12 is comprised between 50 and 200nm. According to an alternative embodiment, a thickness of the top layer 12 is lower than 100nm. The intermediate layer 11 comprises a trap-rich layer 111 and a buried insulator 121 formed on top of the trap-rich layer 111. The buried insulator 121 comprises a layer 131 comprising silicon nitride confined between two layers 132;133 comprising silicon oxide and the trap-rich layer 111 comprises silicon carbide, for example amorphous silicon carbide. According to an alternative embodiment, the buried insulator 121 comprises silicon dioxide and the trap-rich layer 111 comprises silicon carbide, for example amorphous silicon carbide. A thickness of the buried insulator 121 is comprised between 100nm and 500nm. A thickness of the trap-rich layer 111 can be for example tens of nanometers. According to a further alternative embodiment, the buried insulator 121 comprises silicon dioxide and the trap-rich layer 111 comprises silicon. A thickness of the trap-rich layer 111 can be for example several micrometers.

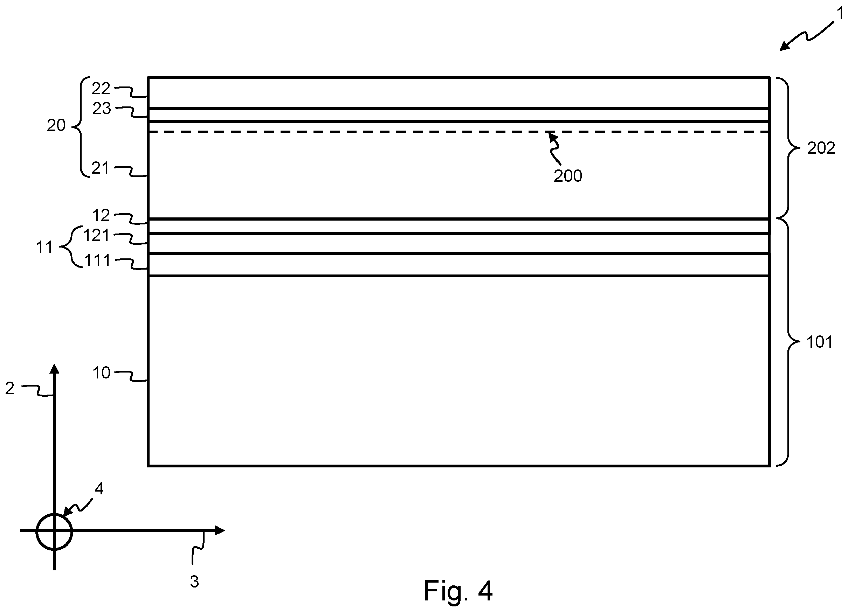

Fig. 4 schematically depicts a cross-section of an example embodiment of a semiconductor structure 1 according to the present disclosure, wherein the cross-section is performed along a plane comprising a growth direction 2, and a traverse direction 3 traverse to the growth direction 2. A third direction 4 is traverse to the growth direction 2 and to the traverse direction 3. Components having identical reference numbers than on Fig. 2 or Fig. 3 fulfill the same function. The semiconductor structure 1 comprises a Silicon-On-Insulator substrate 101 and an epitaxial III-N semiconductor layer stack 202 on top of the Silicon-On-Insulator substrate 101. The Silicon-On-Insulator substrate 101 comprises a base layer 10, an intermediate layer 11 formed on top of the base layer 10, and a top layer 12 formed on top of the intermediate layer 11. The base layer 10 comprises silicon. The resistivity of the base layer 10 is typically comprised between 3 and 5 kOhm.cm, larger than 1 kOhm.cm. The epitaxial III-N semiconductor layer stack 202 comprises an epitaxial active layer 20. The epitaxial active layer 20 comprises a first active III-N layer 21 formed on top of the top layer 12, a spacer layer 23 formed on top of the first active III-N layer 21, and a second active III-N layer formed on top of the spacer layer 23. The first active III-N layer 21 comprises for example gallium nitride and the second active III-N layer 22 for example comprises aluminium gallium nitride. The spacer layer 23 preferably comprises aluminium nitride. A two dimensional Electron Gas 200 is formed between the first active III-N layer 21 and the second active III-N layer 22. The top layer 12 comprises n-type doped silicon. An orientation of the silicon of the top layer 12 is (111). The n-type doping concentration of the top layer 12 is within the range of 1.10¹⁵ cm⁻³ to 5.10¹⁵ cm⁻³. A thickness of the top layer 12 is comprised between 50 and 200nm. According to an alternative embodiment, a thickness of the top layer 12 is lower than 100nm. The intermediate layer 11 comprises a trap-rich layer 111 and a buried insulator 121 formed on top of the trap-rich layer 111. The buried insulator 121 comprises silicon dioxide and the trap-rich layer 111 comprises silicon. A thickness of the buried insulator 121 is comprised between 100nm and 500nm. A thickness of the trap-rich layer 111 can be for example several micrometers. According to an alternative embodiment, the buried insulator 121 comprises silicon dioxide and the trap-rich layer 111 comprises silicon carbide, for example amorphous silicon carbide. A thickness of the trap-rich layer 111 can be for example several micrometers.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention can operate according to the present invention in other sequences, or in orientations different from the one(s) described or illustrated above.

## Claims

1. A semiconductor structure (1) comprising:
- a Silicon-On-Insulator substrate (101) comprising:
∘ a base layer (10) comprising silicon;
∘ an intermediate layer (11) formed on top of said base layer (10); and
∘ a top layer (12) formed on top of said intermediate layer (11);
- an epitaxial III-N semiconductor layer stack (202) on top of said Silicon-On-Insulator substrate (101), said epitaxial III-N semiconductor layer stack (202) comprising an epitaxial active layer (20); wherein said epitaxial active layer (20) comprises:
∘ a first active III-N layer (21) formed on top of said top layer (12);
∘ a second active III-N layer (22) formed on top of said first active III-N layer (21);
with a two dimensional Electron Gas (200) between said first active III-N layer (21) and said second active III-N layer (22);
and wherein:
- said top layer (12) comprises *n*-type doped silicon; and
- said intermediate layer (11) comprises:
∘ a trap-rich layer (111); and
∘ a buried insulator (121) formed on top of the trap-rich layer (111).

2. The semiconductor structure (1) according to claim 1, wherein a n-type doping concentration of said top layer (12) is within the range of 1.10¹⁵ cm⁻³ to 5.10¹⁵ cm⁻³.

3. The semiconductor structure (1) according to any of the preceding claims, wherein a thickness of said top layer (12) is comprised between 50 and 200nm.

4. The semiconductor structure (1) according to any of the preceding claims, wherein an orientation of said *n*-type doped silicon of said top layer (12) is (111).

5. The semiconductor structure (1) according to any of the preceding claims, wherein said buried insulator (121) comprises silicon dioxide and wherein said trap-rich layer (111) comprises silicon.

6. The semiconductor structure (1) according to any of the claims 1 to 3, wherein said buried insulator (121) comprises silicon dioxide and wherein said trap-rich layer (111) comprises amorphous silicon carbide.

7. The semiconductor structure (1) according to any of the claims 1 to 3, wherein said buried insulator (121) comprises a layer (131) comprising silicon nitride confined between two layers (132;133) comprising silicon oxide; and wherein said trap-rich layer (111) comprises amorphous silicon carbide.

8. The semiconductor structure (1) according to any of the preceding claims, wherein a thickness of said buried insulator (121) is comprised between 100nm and 500nm.

9. The semiconductor structure (1) according to any of the preceding claims, wherein said epitaxial III-N semiconductor layer stack (202) further comprises a spacer layer (23) formed between said first active III-N layer (21) and said second active III-N layer (22).

10. The semiconductor structure (1) according to any of the preceding claims, wherein said first active III-N layer (21) comprises gallium nitride and wherein said second active III-N layer (22) comprises aluminium gallium nitride.

11. The semiconductor structure (1) according to claims 9 and 10, wherein said spacer layer (23) comprises aluminium nitride.

12. A method for manufacturing a semiconductor structure (1), wherein said method comprises the steps of:
- providing a Silicon-On-Insulator substrate (101) comprising:
∘ providing a base layer (10) comprising silicon;
∘ providing an intermediate layer (11) on top of said base layer (10) by:
▪ providing a trap-rich layer (111); and
▪ providing a buried insulator (121) formed on top of said trap-rich layer (111); and
∘ providing a top layer (12) comprising n-type doped silicon and formed on top of said intermediate layer (11);
- providing an epitaxial III-N semiconductor layer stack (202) on top of said Silicon-On-Insulator substrate (101), said epitaxial III-N semiconductor layer stack (202) comprising an epitaxial active layer (20); wherein providing said epitaxial active layer (20) comprises the steps of:
∘ providing a first active III-N layer (21) on top of said top layer (12);
∘ providing a second active III-N layer (22) on top of said first active III-N layer (21);
thereby forming a two dimensional Electron Gas (200) between said first active III-N layer (21) and said second active III-N layer (22).

13. The method of claim 12, wherein said providing a top layer (12) comprising *n-*type doped silicon comprises doping said silicon of said top layer (12) by thermal diffusion of *n*-type dopants into said silicon of said top layer (12).

14. The method of claim 12, wherein said providing a top layer (12) comprising *n-*type doped silicon comprises doping said silicon of said top layer (12) by ion implantation of *n*-type dopants into said silicon of said top layer (12).

15. The method of any of the claims 12 to 14, wherein said n-type dopants comprise one or more of the following:
- Phosphorus;
- Arsenic;
- Antimony.

## Patentansprüche

1. Halbleiterstruktur (1), umfassend:
- ein Silicium-auf-Isolator-Substrat (101), umfassend:
∘ eine Basisschicht (10), die Silicium umfasst;
∘ eine Zwischenschicht (11), die oben auf der Basisschicht (10) gebildet ist; und
∘ eine Oberschicht (12), die oben auf der Zwischenschicht (11) gebildet ist;
- einen epitaxialen III-N-Halbleiterschichtstapel (202) oben auf dem Silicium-auf-Isolator-Substrat (101), wobei der epitaxiale III-N-Halbleiterschichtstapel (202) eine epitaxiale aktive Schicht (20) umfasst; wobei die epitaxiale aktive Schicht (20) umfasst:
∘ eine erste aktive III-N-Schicht (21), die oben auf der Oberschicht (12) gebildet ist;
∘ eine zweite aktive III-N-Schicht (22), die oben auf der ersten aktiven III-N-Schicht (21) gebildet ist;
mit einem zweidimensionalen Elektronengas (200) zwischen der ersten aktiven III-N-Schicht (21) und der zweiten aktiven III-N-Schicht (22);
und wobei:
- die Oberschicht (12) n-dotiertes Silicium umfasst; und
- die Zwischenschicht (11) Folgendes umfasst:
∘ eine fallenreiche Schicht (111); und
∘ einen vergrabenen Isolator (121), der oben auf der fallenreichen Schicht (111) gebildet ist.

2. Halbleiterstruktur (1) nach Anspruch 1, wobei eine n-Dotierungskonzentration der Oberschicht (12) innerhalb des Bereichs von 1 x 10¹⁵ cm⁻³ bis 5 x 10¹⁵ cm⁻³ liegt.

3. Halbleiterstruktur (1) nach einem der vorhergehenden Ansprüche, wobei eine Dicke der Oberschicht (12) zwischen 50 und 200 nm umfasst ist.

4. Halbleiterstruktur (1) nach einem der vorhergehenden Ansprüche, wobei eine Orientierung des *n*-dotierten Siliciums der Oberschicht (12) auf (111) lautet.

5. Halbleiterstruktur (1) nach einem der vorhergehenden Ansprüche, wobei der vergrabene Isolator (121) Siliciumdioxid umfasst und wobei die fallenreiche Schicht (111) Silicium umfasst.

6. Halbleiterstruktur (1) nach einem der Ansprüche 1 bis 3, wobei der vergrabene Isolator (121) Siliciumdioxid umfasst und wobei die fallenreiche Schicht (111) amorphes Siliciumcarbid umfasst.

7. Halbleiterstruktur (1) nach einem der Ansprüche 1 bis 3, wobei der vergrabene Isolator (121) eine Schicht (131) umfasst, die Siliciumnitrid umfasst, das zwischen zwei Schichten (132; 133), die Siliciumoxid umfassen, eingeschlossen ist; und wobei die fallenreiche Schicht (111) amorphes Siliciumcarbid umfasst.

8. Halbleiterstruktur (1) nach einem der vorhergehenden Ansprüche, wobei eine Dicke des vergrabenen Isolators (121) zwischen 100 nm und 500 nm umfasst ist.

9. Halbleiterstruktur (1) nach einem der vorhergehenden Ansprüche, wobei der epitaxiale III-N-Halbleiterschichtstapel (202) ferner eine Abstandsschicht (23) umfasst, die zwischen der ersten aktiven III-N-Schicht (21) und der zweiten aktiven III-N-Schicht (22) gebildet ist.

10. Halbleiterstruktur (1) nach einem der vorhergehenden Ansprüche, wobei die erste aktive III-N-Schicht (21) Galliumnitrid umfasst und wobei die zweite aktive III-N-Schicht (22) Aluminiumgalliumnitrid umfasst.

11. Halbleiterstruktur (1) nach Ansprüchen 9 und 10, wobei die Abstandsschicht (23) Aluminiumnitrid umfasst.

12. Verfahren zur Herstellung einer Halbleiterstruktur (1), wobei das Verfahren die folgenden Schritte umfasst:
- Bereitstellen eines Silicium-auf-Isolator-Substrats (101), umfassend:
∘ Bereitstellen einer Basisschicht (10), die Silicium umfasst;
∘ Bereitstellen einer Zwischenschicht (11) oben auf der Basisschicht (10) durch:
▪ Bereitstellen einer fallenreichen Schicht (111); und
▪ Bereitstellen eines vergrabenen Isolators (121), der oben auf der fallenreichen Schicht (111) gebildet ist; und
o Bereitstellen einer Oberschicht (12), die n-dotiertes Silicium umfasst und oben auf der Zwischenschicht (11) gebildet ist;
- Bereitstellen eines epitaxialen III-N-Halbleiterschichtstapels (202) oben auf dem Silicium-auf-Isolator-Substrat (101), wobei der epitaxiale III-N-Halbleiterschichtstapel (202) eine epitaxiale aktive Schicht (20) umfasst; wobei das Bereitstellen der epitaxialen aktiven Schicht (20) die folgenden Schritte umfasst:
∘ Bereitstellen einer ersten aktiven III-N-Schicht (21) oben auf der Oberschicht (12);
∘ Bereitstellen einer zweiten aktiven III-N-Schicht (22) oben auf der ersten aktiven III-N-Schicht (21);
wodurch ein zweidimensionales Elektronengas (200) zwischen der ersten aktiven III-N-Schicht (21) und der zweiten aktiven III-N-Schicht (22) gebildet wird.

13. Verfahren nach Anspruch 12, wobei das Bereitstellen einer Oberschicht (12), die *n-*dotiertes Silicium umfasst, das Dotieren des Siliciums der Oberschicht (12) durch thermische Diffusion von *n*-Dotierstoffen in das Silicium der Oberschicht (12) umfasst.

14. Verfahren nach Anspruch 12, wobei das Bereitstellen einer Oberschicht (12), die *n-*dotiertes Silicium umfasst, das Dotieren des Siliciums der Oberschicht (12) durch Ionenimplantation von *n*-Dotierstoffen in das Silicium der Oberschicht (12) umfasst.

15. Verfahren nach einem der Ansprüche 12 bis 14, wobei die n-Dotierstoffe eines oder mehrere der folgenden umfassen:
- Phosphor;
- Arsen;
- Antimon.

## Revendications

1. Structure semi-conductrice (1) comprenant :
- un substrat de silicium sur isolant (101) comprenant :
∘ une couche de base (10) comprenant du silicium ;
∘ une couche intermédiaire (11) formée sur le dessus de ladite couche de base (10) ; et
∘ une couche supérieure (12) formée sur le dessus de ladite couche intermédiaire (11) ;
- un empilement de couches semi-conductrices III-N épitaxiales (202) sur le dessus dudit substrat de silicium sur isolant (101), ledit empilement de couches semi-conductrices III-N épitaxiales (202) comprenant une couche active épitaxiale (20) ; ladite couche active épitaxiale (20) comprenant :
∘ une première couche III-N active (21) formée sur le dessus de ladite couche supérieure (12) ;
∘ une seconde couche III-N active (22) formée sur le dessus de ladite première couche III-N active (21) ;
avec un gaz électronique bidimensionnel (200) entre ladite première couche III-N active (21) et ladite seconde couche III-N active (22) ;
et :
- ladite couche supérieure (12) comprenant du silicium dopé de type *n* ; et
- ladite couche intermédiaire (11) comprenant :
∘ une couche riche en pièges (111) ; et
∘ un isolant enterré (121) formé sur le dessus de la couche riche en pièges (111).

2. Structure semi-conductrice (1) selon la revendication 1, la concentration de dopant de type *n* de ladite couche supérieure (12) se trouvant dans la plage de 1 x 10¹⁵ cm⁻³ à 5 x 10¹⁵ cm⁻³.

3. Structure semi-conductrice (1) selon l'une quelconque des revendications précédentes, une épaisseur de ladite couche supérieure (12) étant comprise entre 50 et 200 nm.

4. Structure semi-conductrice (1) selon l'une quelconque des revendications précédentes, l'orientation dudit silicium dopé de type *n* de ladite couche supérieure (12) étant (111).

5. Structure semi-conductrice (1) selon l'une quelconque des revendications précédentes, ledit isolant enterré (121) comprenant du dioxyde de silicium et ladite couche riche en pièges (111) comprenant du silicium.

6. Structure semi-conductrice (1) selon l'une quelconque des revendications 1 à 3, ledit isolant enterré (121) comprenant du dioxyde de silicium et ladite couche riche en pièges (111) comprenant du carbure de silicium amorphe.

7. Structure semi-conductrice (1) selon l'une quelconque des revendications 1 à 3, ledit isolant enterré (121) comprenant une couche (131) comprenant du nitrure de silicium confiné entre deux couches (132 ; 133) comprenant de l'oxyde de silicium ; et ladite couche riche en pièges (111) comprenant du carbure de silicium amorphe.

8. Structure semi-conductrice (1) selon l'une quelconque des revendications précédentes, une épaisseur dudit isolant enterré (121) étant comprise entre 100 nm et 500 nm.

9. Structure semi-conductrice (1) selon l'une quelconque des revendications précédentes, ledit empilement de couches semi-conductrices III-N épitaxiales (202) comprenant en outre une couche d'espacement (23) formée entre ladite première couche III-N active (21) et ladite seconde couche III-N active (22).

10. Structure semi-conductrice (1) selon l'une quelconque des revendications précédentes, ladite première couche III-N active (21) comprenant du nitrure de gallium et ladite seconde couche III-N active (22) comprenant du nitrure de gallium et d'aluminium.

11. Structure semi-conductrice (1) selon les revendications 9 et 10, ladite couche d'espacement (23) comprenant du nitrure d'aluminium.

12. Procédé permettant la fabrication d'une structure semi-conductrice (1), ledit procédé comprenant les étapes de :
- fourniture d'un substrat de silicium sur isolant (101) comprenant :
∘ la fourniture d'une couche de base (10) comprenant du silicium ;
∘ la fourniture d'une couche intermédiaire (11) sur le dessus de ladite couche de base (10) par :
▪ la fourniture d'une couche riche en pièges (111) ; et
▪ la fourniture d'un isolant enterré (121) formé sur le dessus de ladite couche riche en pièges (111) ; et
∘ la fourniture d'une couche supérieure (12) comprenant du silicium dopé de type *n* et formée sur le dessus de ladite couche intermédiaire (11) ;
- la fourniture d'un empilement de couches semi-conductrices III-N épitaxiales (202) sur le dessus dudit substrat de silicium sur isolant (101), ledit empilement de couches semi-conductrices III-N épitaxiales (202) comprenant une couche active épitaxiale (20) ; ladite fourniture de ladite couche active épitaxiale (20) comprenant les étapes de :
∘ fourniture d'une première couche III-N active (21) sur le dessus de ladite couche supérieure (12) ;
∘ fourniture d'une seconde couche III-N active (22) sur le dessus de ladite première couche III-N active (21) ;
ce qui permet la formation d'un gaz électronique bidimensionnel (200) entre ladite première couche III-N active (21) et ladite seconde couche III-N active (22).

13. Procédé de la revendication 12, ladite fourniture d'une couche supérieure (12) comprenant du silicium dopé de type *n* comprenant le dopage dudit silicium de ladite couche supérieure (12) par diffusion thermique de dopants de type *n* dans ledit silicium de ladite couche supérieure (12).

14. Procédé de la revendication 12, ladite fourniture d'une couche supérieure (12) comprenant du silicium dopé de type *n* comprenant le dopage dudit silicium de ladite couche supérieure (12) par implantation ionique de dopants de type *n* dans ledit silicium de ladite couche supérieure (12).

15. Procédé de l'une quelconque des revendications 12 à 14, lesdits dopants de type *n* comprenant un ou plusieurs des dopants suivants :
- le phosphore ;
- l'arsenic ;
- l'antimoine.
